# EUROPÄISCHE PATENTSCHRIFT

(11) **EP 0 455 174 B1**
(45) Veröffentlichungstag und Bekanntmachung des Hinweises auf die Patenterteilung: **04.06.1997**
(21) Anmeldenummer: 91106864.1
(22) Anmeldetag: 27.04.1991
(51) Int. Cl.: G05B 19/042

(54) **Steuervorrichtung für technische Anlagen und Maschinen insbesondere für Brennkraftmaschinen von Kraftfahrzeugen**
Control device for technical equipment and machines, especially for internal combustion engines of automotive vehicles
Dispositif de commande pour équipements techniques et machines, en particulier pour moteurs à combustion interne de véhicules automobiles

(30) Priorität: 28.04.1990 DE 4013727
(43) Veröffentlichungstag der Anmeldung: 06.11.1991
(73) Patentinhaber: Bayerische Motoren Werke Aktiengesellschaft, 80788 München (DE)
(72) Erfinder: Hohenner, Hans, W-8000 München 2 (DE); Heidenreich, Andreas, W-8000 München 50 (DE)

(56) Entgegenhaltungen:
- EP-A- 0 067 611
- EP-A- 0 155 403
- FR-A- 2 402 239
- US-A- 4 246 442
- US-A- 4 349 695
- US-A- 4 679 236

## Beschreibung

Die Erfindung bezieht sich auf ein Steuergerät nach dem Oberbegriff des Patentanspruchs 1.

Funktionsrelevante Daten von Steuergeräten insbesondere beim Einsatz in Kraftfahrzeugen werden zunehmend am Montageband für das neue Fahrzeug bzw. in den Werkstätten einprogrammiert. Dabei bestehen einerseits die Forderungen, diesen Vorgang möglichst einfach zu gestalten und schnell ablaufen zu lassen. Andererseits aber ergibt sich die Gefahr einer unberechtigten Manipulation des Speicherinhalts.

Aus der EP-A 0 155 403 ist ein Steuergerät der eingangs genannten Art bekannt. bei dem das Programmiergerät eine Adressierung mindestens dreimal in ungerader Parität an das Steuergerät sendet. Nachdem das Steuergerät mindestens dreimal ein Wort ungerader Parität empfangen hat, sendet es ein Quittierungssignal an das Programmiergerät zurück. Damit erkennt das Programmiergerät, daß das Steuergerät programmierbereit ist. Ein besonderer Schutz vor einer unberechtigten Manipulation des Speicherinhalts ist damit nicht verbunden.

Aus der US-A 4 349 695 ist ein EDV-System mit mehreren Terminals und einem Host-Computer bekannt. Die Terminals sind gleichberechtigt. Dabei wird mit Hilfe von Chiffre- und Dechiffre-Vorgängen erreicht, die Terminals einerseits gleichzeitig arbeiten zu lassen und andererseits für den Host-Computer voneinander zu unterscheiden. Ein besonderer Manipulationsschutz ist dabei ebenfalls nicht vorgesehen.

Der Erfindung liegt die Aufgabe zugrunde, ein Steuergerät der eingangs genannten Art zu schaffen, das auf einfache und sichere Weise eine schnelle Beschreibung des Speichers mit den jeweiligen Daten ermöglicht und das andererseits aber sicher vor einer unerwünschten Manipulation dieser Daten ist.

Die Erfindung löst diese Aufgabe durch die kennzeichnenden Merkmale des Patentanspruchs 1.

Die erfindungsgemäße Zugangsroutine kann mit Hilfe des externen Programmiergeräts schnell und praktisch unbemerkt für den berechtigten Benutzer ablaufen. Sofern das Programmiergerät "paßt", kann ohne zusätzliche und vorbereitende Maßnahmen der Speicher mit den richtigen Daten geladen werden.

Die Zugangsroutine ihrerseits ist jedoch so gestaltet, daß sie für einen nicht berechtigten Benutzer ohne das Programmiergerät nicht oder nur unter erheblich erschwerten Bedingungen nachvollzogen werden kann. Da im Rahmen der Zugangsroutine die Antwort, d.h. das vom Steuergerät gelieferte Anwortsignal in einer definierten und für einen Unbefugten nicht unmittelbaren erkennbaren Weise in das Zugangssignal umgesetzt wird, läßt sich damit auch ein hohes Maß an Sicherheit erreichen.

Da verschiedene Steuergeräte, beispielweise für verschiedene Fahrzeugvarianten ein und desselben Fahrzeugmodells, ein unterschiedliches Anwortsignal liefern, das nach der Umsetzung weiterhin eine individuelle Charakteristik beibehält, können somit die für verschiedene Steuergeräte zwar hinsichtlich ihres Ablaufs gleich verlaufenden, hinsichtlich des Inhalts der weitergegebenen Signale jedoch unterschiedlichen Abläufe für einen nicht berechtigten Benutzer nicht nachvollzogen werden.

Die Umwandlung der Anwortsignale im Programmiergerät kann beispielsweise in Form einer analogen oder binären Codierung vorgenommen werden. Stets jedoch erfolgt innerhalb des Programmiergeräts eine elektronische Bearbeitung des Antwortsignals vor der erneuten Eingabe als Zugangssignal in das Steuergerät. Nur dann, wenn diese Bearbeitung in der vom Hersteller der Anlage oder Maschine vorgegebenen Weise vollzogen wird, ist der eigentliche Programmiervorgang durchführbar.

Weitere Maßnahmen dienen dazu, die Sicherheit der durchgeführten Zugangsroutine weiter zu erhöhen. Sie sind Gegenstand der Patentansprüche 2 bis 4. Dabei ergeben sich als besondere Vorteile beim Gegenstand des Patentanspruchs
2 der mit der zeitlichen Begrenzung verbundene Schutz vor einer Nachahmung der Zugangsroutine mit von dem Programmiergerät abweichenden elektronischen Komponenten
3 der gegenüber einem standardisierten Fragebefehl mögliche Ausschluß eines Unbefugten anhand des allein dem Befugten zur Verfügung stehenden zulässigen Fragebefehls und
4 durch die Verwendung mindestens zweier verschiedener Leitungen (für den Datenfluß und die Programmierspannung) eine weitere Erhöhung der Sicherheit des Dialogs zwischen Programmiergerät und Steuergerät. Dabei wird durch die Programmierspannung während des Programmiervorgangs das Steuergerät für die Aufnahme der Daten in den programmierbaren Speicher aktiviert.

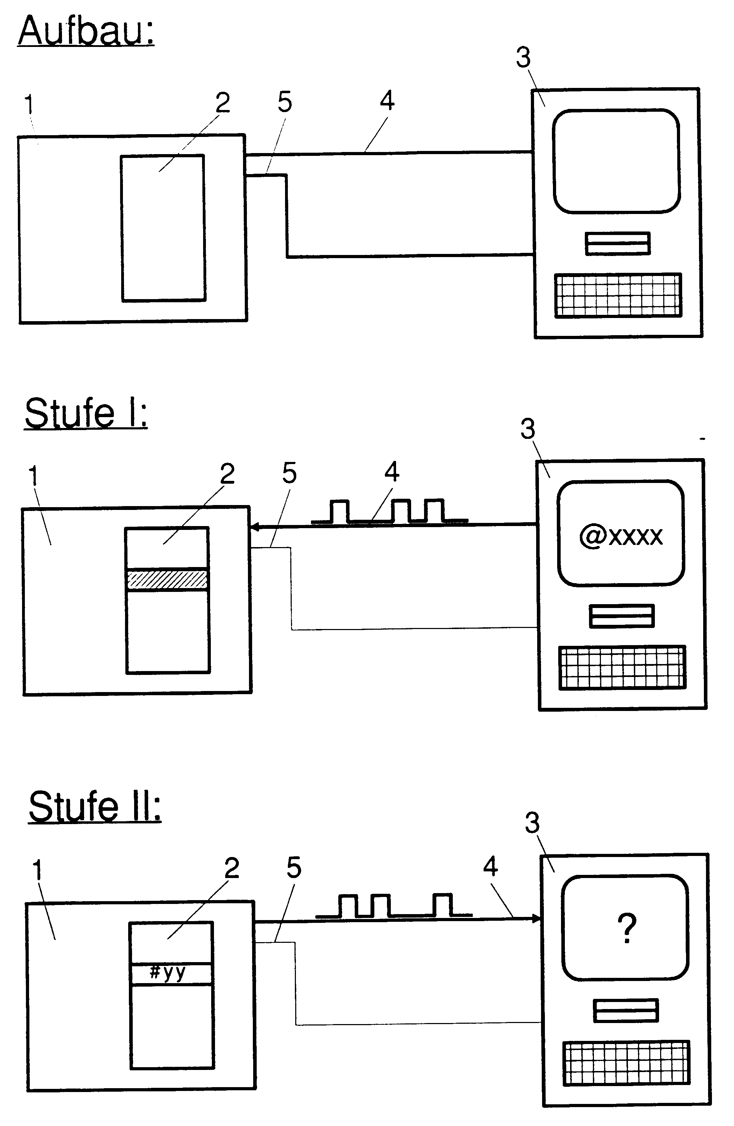

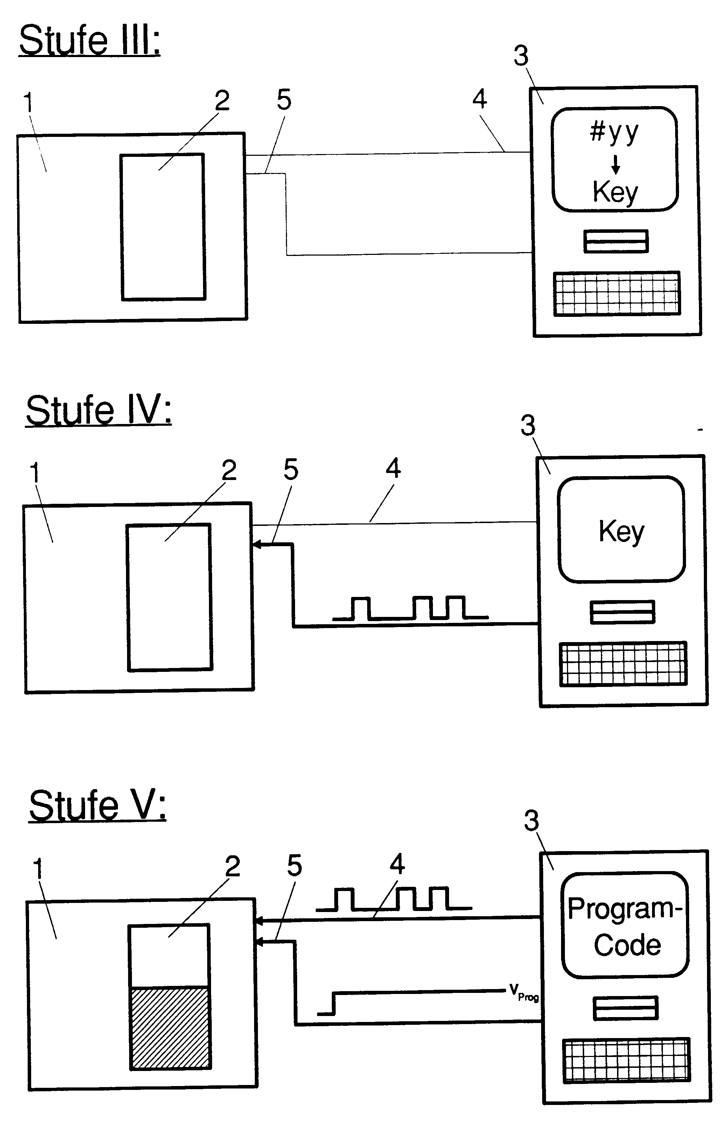

Anhand der Zeichnung ist die Erfindung weiter erläutert. Dabei ist der Dialog zwischen einem Steuergerät 1 mit einem programmierbaren Speicher 2 und einem externen Programmiergerät 3 dargestellt. Mit "Aufbau" ist die Schaltungsanordnung, mit "Stufe I"-"Stufe V" der Ablauf der Zugangsroutine, d.h. des Dialogs dargestellt.

Das Steuergerät 1 und das Programmiergerät 3 sind über mindestens zwei Leitungen 4 und 5 miteinander verbunden. Dabei dient die Leitung 4 als Datenleitung, während die Leitung 5 das Steuergerät 1 mit der sog. Programmierspannung versorgt.

Der Dialog zwischen dem Steuergerät 1 und dem Programmiergerät 3 vollzieht sich in fünf Stufen I bis V und verbunden damit mit einem Signalfluß, der für die Stufen I bis V durch Pfeile auf den dafür verwendeten Leitungen 4 bzw. 5 dargestellt ist.

In der Stufe I sendet das Programmiergerät 3 einen Fragebefehl über die Leitung 4 an das Steuergerät 1 aus. Der Fragebefehl kann allgemeiner Art sein bzw. eine Adresse enthalten. Dabei kann es sich um die Adresse (xxxxx) einer vorgegebenen, beispielsweise mit dem Hersteller des Steuergeräts abgesprochenen Speicherzelle handeln.

Das Steuergerät gibt in Stufe II ein Anwortsignal über die Leitung 4 zurück. Es handelt sich dabei um den Inhalt dieser Speicherzelle, beispielsweise eine Zahl mit dem Wert "9", symbolisiert mit "# yy".

In der Stufe III wird dieses Antwortsignal im Programmiergerät 3 in ein codiertes Zugangssignal umgesetzt. Es wird beispielsweise um den Wert "1" hier also auf den Wert "8" verringert. Wesentlich dabei ist, daß sich das Zugangs- vom Antwortsignal in definierter Weise unterscheidet. Dieser Unterschied kann durch einen Schlüssel (Key) vorgegeben sein, mit dem das Antwortsignal umgesetzt wird.

Dieses Zugangssignal wird in der Stufe IV über die Programmierspannungsleitung 5 an das Steuergerät 1 gesandt. Dabei kann es sich beispielsweise um ein binäres Signal (hier für den Wert "8") handeln, das entsprechend dem Antwortsignal von Stufe II als Impulsfolge weitergegeben wird.

Anschließend daran erfolgt in Stufe V, wie an sich bekannt, die Programmierung des Speichers 2 über die Datenleitung 4 durch das Programmiergerät 3, wobei die Leitung 5 ihre reguläre Funktion, die Programmierspannungszuführung, übernimmt.

Diese Programmierung durch Übergabe der im Speicher 2 aufzunehmenden Daten kann nur dann erfolgen, wenn die Zugangsroutine erfolgreich abgeschlossen ist. Das Steuergerät 1 sorgt dafür, daß nur bei ordnungsgemäßen Ablauf des Dialogs der Speicher 2 beschrieben werden kann. Dies wird durch das Steuergerät verifiziert, indem das - aus dem Antwortsignal durch das Programmiergerät in definierter Weise gebildete - Zugangssignal mit einem im Steuergerät auf dieselbe Weise aus den Antwortsignal bzw. aus dem Inhalt der abgefragten Speicherzelle gebildeten Kontrollsignal verglichen wird. Nur beim berechtigten Nutzer stimmen das Antwortsignal und das Kontrollsignal überein.

Als weitere Kontrollen zählen hierzu der Vergleich des Fragebefehls (Stufe I), der beispielsweise eine definierte Form besitzen muß, sowie die Einhaltung eines vorgegebenen Zeitrahmens für diesen Dialog. Ist dieser Rahmen überschritten, so wird auch dann die Programmierung des Speichers nicht freigegeben.

Damit ist ein Höchstmaß an Sicherheit für die Programmierung des Speichers 2 erreicht. Die Zugangskontrolle ist dem eigentlichen Programmiervorgang vorgeschaltet und dient dazu, den berechtigten Programmierer zu identifizieren bzw. Unbefugte von der Manipulation des Speichers 2 auszuschließen.

## Patentansprüche

1. Steuergerät für technische Anlagen und Maschinen, insbesondere für Brennkraftmaschinen von Kraftfahrzeugen, mit einem Mikroprozessor, einem fest programmierten Speicher und einem durch ein extemes Programmiergerät (3) frei programmierbaren, wieder löschbaren Speicher (2), bei dem vor dem Beschreiben des programmierbaren Speichers (2) eine Zugangsroutine abläuft, wobei das externe Programmiergerät (3) einen Fragebefehl aussendet und daraufhin das Steuergerät (1) eine dem Fragebefehl entsprechende Antwort gibt, dadurch gekennzeichnet, daß das externe Programmiergerät (3) die Antwort umwandelt in ein dem Inhalt der Antwort entsprechendes Zugangssignal, daß das Programmiergerät (3) das Zugangssignal an das Steuergerät (1) liefert und daß das Steuergerät (1) nur bei Übereinstimmung des Zugangssignals mit einem im Steuergerät (1) gebildeten identischen Kontrollsignal die Beschreibung des Speichers (2) erlaubt.

2. Steuergerät nach Anspruch 1, dadurch gekennzeichnet, daß das Steuergerät (1) die Beschreibung des Speichers (2) nur dann erlaubt, wenn die Zugangsroutine innerhalb einer vorgegebenen Dialogzeit abgeschlossen ist.

3. Steuergerät nach Anspruch 1 oder 2, dadurch gekennzeichnet, daß der Fragebefehl auf den Inhalt einer festgelegten Stelle des vom Mikroprozessor durchgeführten Betriebsprogramms bzw. eines zugeordneten Speichers gerichtet ist.

4. Steuergerät nach einem der Ansprüche 1 bis 3, dadurch gekennzeichnet, daß das Zugangssignal über eine Leitung in das Steuergerät (1) eingegeben ist, an der während der Beschreibung des Speichers eine Programmierspannung am Steuergerät anliegt.

## Claims

1. A control device for industrial installations and machines, especially internal combustion engines of motor vehicles, comprising a microprocessor, a read-only memory and a re-erasable memory (2) which can be freely programmed by an external programming device (3), wherein before data are entered in the programmable memory (2) an access routine is carried out, in which the external programming device (3) transmits an interrogation command and the control device (1) thereupon delivers an answer corresponding to the interrogation command, characterised in that the external programming device (3) converts the answer into an access signal corresponding to the content of the answer, that the programming device (3) delivers the access signal to the control device (1), and the control device (1) does not allow an entry to be made in the memory (2) unless the access signal coincides with an identical control signal formed in the control device (1).

2. A control device according to claim 1, characterised in that the control device (1) only allows an entry to be made in the memory (2) if the access routine has been completed within a preset dialogue time.

3. A control device according to claim 1 or 2, characterised in that the interrogation command relates to the content of a fixed location in the operating program carried out by the microprocessor or in an associated memory.

4. A control device according to any of claims 1 to 3, characterised in that the access signal is input into the control device (1) via a line along which a programming voltage is applied to the control device while an entry is being made in the memory.

## Revendications

1. Appareil de commande pour des installations techniques et des machines, en particulier pour des moteurs à combustion interne de véhicules automobiles comprenant un microprocesseur, une mémoire programmée de manière fixe et une mémoire (2) librement programmable par un appareil de programmation externe (3) et à nouveau effaçable, appareil dans lequel, avant l'inscription de la mémoire programmable (2), s'effectue une routine d'accès, dans laquelle l'appareil de programmation externe (3) délivre un ordre d'interrogation et qu'à la suite de cela l'appareil de commande (1) donne une réponse correspondant à l'ordre d'interrogation,
caractérisé en ce que
- l'appareil de programmation externe (3) transforme la réponse en un signal d'accès correspondant au contenu de la réponse,
- l'appareil de programmation (3) délivre le signal d'accès à l'appareil de commande (1) et
- l'appareil de commande (1) ne permet l'inscription de la mémoire (2) qu'après la comparaison du signal d'entrée avec le signal de contrôle identique formé dans l'appareil de commande (1).

2. Appareil de commande selon la revendication 1,
caractérisé en ce que
l'appareil de commande (1) n'autorise l'inscription de la mémoire (2), que lorsque la routine de processus a été réalisée à l'intérieur d'un temps de dialogue prédéterminé.

3. Appareil de commande selon la revendication 1 ou 2,
caractérisé en ce que
l'ordre de commande est dirigé vers le contenu d'un emplacement fixe du programme effectué par le microprocesseur ou de la mémoire associée.

4. Appareil de commande selon l'une des revendications 1 à 3,
caractérisé en ce que
le signal d'entrée est entré dans l'appareil de commande (1) par une ligne soumise à une tension de programmation pendant l'inscription de la mémoire.
